# EUROPÄISCHE PATENTSCHRIFT

(11) **EP 1 090 415 B1**
(45) Veröffentlichungstag und Bekanntmachung des Hinweises auf die Patenterteilung: **17.11.2010**
(21) Anmeldenummer: 99938136.1
(22) Anmeldetag: 07.06.1999
(51) Int. Cl.: H01L 21/04, H01L 29/45

(54) **HALBLEITERANORDNUNG MIT OHMSCHER KONTAKTIERUNG UND VERFAHREN ZUR KONTAKTIERUNG EINER HALBLEITERANORDNUNG**
SEMICONDUCTOR ARRANGEMENT WITH OHMIC CONTACT AND A METHOD FOR CONTACTING A SEMICONDUCTOR ARRANGEMENT
DISPOSITIF A SEMI-CONDUCTEUR AVEC CONTACT OHMIQUE ET PROCEDE DE REALISATION D'UN CONTACT SUR UN DISPOSITIF A SEMI-CONDUCTEUR

(30) Priorität: 08.06.1998 DE 19825519
(43) Veröffentlichungstag der Anmeldung: 11.04.2001
(73) Patentinhaber: SiCED Electronics Development GmbH & Co KG, 91052 Erlangen (DE)
(72) Erfinder: FRIEDRICHS, Peter, D-90419 Nürnberg (DE); PETERS, Dethard, D-91315 Höchstadt (DE); SCHÖRNER, Reinhold, D-91091 Großenseebach (DE)
(74) Vertreter: Maier, Daniel Oliver
(86) Internationale Anmeldenummer: PCT/DE1999/001659
(87) Internationale Veröffentlichungsnummer: WO 1999/065067

(56) Entgegenhaltungen:
- WO-A-95/24055
- US-A- 5 124 779
- PORTER L M ET AL: "A CRITICAL REVIEW OF OHMIC AND RECTIFYING CONTACTS FOR SILICON CARBIDE" MATERIALS SCIENCE AND ENGINEERING B,CH,ELSEVIER SEQUOIA, LAUSANNE, Bd. B34, Nr. 2/03, Seite 83-105 XP000627607 ISSN: 0921-5107
- DMITRIEV V A ET AL: "LOW RESISTIVITY ( 10-5 CM2) OHMIC CONTACTS TO 6H SILICON CARBIDE FABRICATED USING CUBIC SILICON CARBIDE CONTACT LAYER" APPLIED PHYSICS LETTERS,US,AMERICAN INSTITUTE OF PHYSICS. NEW YORK, Bd. 64, Nr. 3, Seite 318-320 XP000424196 ISSN: 0003-6951

## Beschreibung

Die Erfindung bezieht sich auf eine Halbleiteranordnung mit ohmscher Kontaktierung sowie auf ein Verfahren zur Kontaktierung einer Halbleiteranordnung.

Die Erfindung betrifft insbesondere eine derartige Halbleiteranordnung, die zumindest in bestimmten Halbleitergebieten, insbesondere den Halbleitergebieten, die kontaktiert werden, aus einem vorbestimmten Polytyp des Siliciumcarbids besteht.

Siliciumcarbid (SiC) in einkristalliner Form ist ein Halbleitermaterial mit hervorragenden physikalischen Eigenschaften, die dieses Halbleitermaterial unter anderem aufgrund seiner hohen Durchbruchfeldstärke und seiner guten thermischen Leitfähigkeit besonders für die Leistungselektronik auch noch bei Anwendungen im kV-Bereich interessant erscheinen lassen. Da die kommerzielle Verfügbarkeit einkristalliner Substratwafer speziell aus Siliciumcarbid des 6H- und 4H-Polytyps gestiegen ist, finden nun auch Leistungshalbleiter Bauelemente auf Siliciumcarbidbasis wie z.B. Schottky-Dioden zunehmend an Beachtung. Andere Siliciumcarbid-Bauelemente mit steigendem Verbreitungsgrad sind pn-Dioden und Transistoren wie beispielsweise MOSFET's (Metal Oxide Semiconductor Field Effect Transistors).

Für die Funktion dieser Bauelemente sind stabile ohmsche Kontakte zu Halbleitergebieten unterschiedlichen Leitungstyps unabdingbar. Dabei werden möglichst niedrige Kontaktwiderstände angestrebt, um unerwünschte Verluste am Übergang Halbleiter-Metall zu minimieren.

In dem Übersichtsaufsatz "Ohmic contacts to SiC" von G.L: Harris et al. aus "Properties of Silicon Carbide" ed. by G.L. Harris INSPEC, 1995, Seiten 231-234 findet sich eine Zusammenstellung von Kontaktierungsverfahren für Siliciumcarbid verschiedenen Polytyps und Leitungstyps. Bezüglich der Kontaktierung von n- und p-leitendem SiC ist dem Übersichtsaufsatz sowie den zitierten Querreferenzen der in der Fachwelt derzeit allgemein anerkannte Kenntnisstand zu entnehmen, der im folgenden skizziert wird:
Der genannte Übersichtsaufsatz gibt nur Verfahren an, bei denen Siliciumcarbid jeweils nur eines einzigen Leitungstyps mit einem ohmschen Kontakt versehen wird.

Die Kontaktierung von n-leitendem SiC erfolgt demgemäß über eine dünne Kontaktschicht eines Metalls oder über Schichtfolge unterschiedlicher Materialien. Die Kontaktschichten werden bei Temperaturen zwischen 600°C und 1100°C getempert. Insbesondere Übergangsmetalle wie beispielsweise Nickel liefern nach der Temperaturbehandlung auf n-leitendem hochdotierten SiC einen sehr guten ohmschen Kontakt, da sich bei Temperaturen von um die 1000°C aus dem Übergangsmetall und dem im SiC enthaltenen Silicium ein Metallsilicid bildet. Kontakttechniken für n-leitendes SiC, die ohne eine entsprechende Temperaturbehandlung arbeiten, liefern im Vergleich dazu einen relativ hohen Kontaktwiderstand oder eine nicht dem ohmschen Gesetz entsprechende Strom-Spannungscharakteristik. Die Temperaturbehandlung wirkt sich darüber hinaus auch positiv auf die Temperaturstabilität der gebildeten ohmschen Kontakte aus.

Zur Kontaktierung von p-leitendem SiC wird überwiegend Aluminium verwendet. Da Aluminium in SiC gut löslich ist und als Akzeptor wirkt, kann in einem Grenzbereich zwischen dem Aluminium enthaltenden Kontaktgebiet und dem Halbleitergebiet aus SiC eine mit Aluminium hochdotierte Zone erzeugt werden. Um ein Abdampfen des Aluminiums, das bereits bei 659°C schmilzt, bei einer nachfolgenden Temperaturbehandlung zu vermeiden, wird auf dem Aluminium mindestens eine Deckschicht aus einem Material mit einem höheren Schmelzpunkt wie z.B. Nickel, Wolfram, Titan oder Tantal aufgebracht.

In dem Aufsatz *"* Thermally stable low ohmic contacts to p-type 6H-SiC using cobalt silicides" von N.Lundberg, M.Östling aus Solid-State Electronics, Vol. 39, No. 11, Seiten 1559-1565, 1996 wird ein Verfahren zur Kontaktierung von p-leitendem SiC offenbart, das sich der Bildung von Kobaltsilicid (CoSi₂) bedient. Mit dem beschriebenen Verfahren und dem verwendeten Kontaktmaterial ist ein sehr niedriger Kontaktwiderstand zu erreichen.

In dem Aufsatz *"*Reduction of Ohmic Contact Resistance on n-Type 6H-SiC by Heavy Doping" von T. Uemoto, Japanese Journal of Applied Physics, Vol. 34, 1995, Seiten L7 bis L9 wird ein Schichtaufbau aus einer 15 nm dicken Titan-Schicht und einer 150 nm dicken Aluminium-Schicht als möglicher ohmscher Kontakt sowohl auf p-leitendem als auch auf n-leitendem Siliciumcarbid offenbart. Ein guter Kontaktwiderstand auf dem n-leitenden Halbleitergebiet wird jedoch nur dann erzielt, wenn die Dotierstoffkonzentration in dem n-leitenden Halbleitergebiet sehr hoch gewählt wird. Die offenbarte Dotierstoffkonzentration von 4,5·10²⁰ cm⁻³ liegt erheblich über den zur Zeit üblicherweise in einer Siliciumcarbid-Halbleiteranordnung verwendeten Dotierstoffkonzentrationen. Eine solch hohe Dotierstoffkonzentration läßt sich nur mit erheblichem Zusatzaufwand herstellen. So besteht z.B. beim Ionenimplantieren die Gefahr, daß das n-leitende Halbleitergebiet geschädigt wird.

Die WO 95/24055 A1 beschreibt einen sog. MIS-Feldeffekttransistor (MIS:= Metal-Insulator-Semiconductor), dessen seitlich neben der MIS-Struktur angeordnete Source-Elektrode sowohl ein n⁺-dotiertes SiC-Halbleitergebiet als auch ein die Kanalzone des Transistors aufnehmendes, p-dotiertes SiC-Basisgebiet kontaktiert.

Aus der US-A-5 124 779 ist ein SiC-Halbleiterbauelement bekannt, dessen ohmscher Kontakt aus einer Titan-AluminiumLegierung besteht. Die als Kontaktelektrode dienende Legierung haftet dann besonders gut auf einer n- oder p-dotierten SiC-Schicht, wenn der Aluminiumanteil am Gesamtgewicht der Legierung im Bereich zwischen 15% und 65% liegt.

Aus L.M.Porter et al: "A critical review of ohmic and rectifying contacts for silicon carbide", Materials Science and Engineering B, Band 34 (1995) S. 83 - 105 ist bekannt, eine als Schottky-Kontakt dienende NiAl-Metallisierung mittels Elektronenstrahlverdampfung im Vakuum bei Zimmertemperatur auf p-dotiertem SiC abzuscheiden.

Es ist Aufgabe der Erfindung, eine Halbleiteranordnung sowie ein Verfahren der eingangs bezeichneten Art mit einer im Vergleich zum Stand der Technik verbesserten Kontaktierung von n- und p-leitendem SiC anzugeben. Dabei sollen die Kontakte auf dem n- und p-leitenden Halbleitergebiet jeweils sowohl einen niedrigen Kontaktwiderstand haben als auch temperaturstabil sein. Außerdem sollen für das n- und p-leitende SiC nur Dotierstoffkonzentrationen vorgesehen werden, die sich mit derzeit verfügbaren Technologien einfach herstellen lassen.

Zur Lösung der die Halbleiteranordnung betreffenden Teilaufgabe wird eine Halbleiteranordnung entsprechend den Merkmalen des unabhängigen Patentanspruches 1 angegeben.

Zur Lösung der das Verfahren betreffenden Teilaufgabe wird ein Verfahren entsprechend den Merkmalen des unabhängigen Patentanspruchs 7 angegeben.

Die Erfindung beruht dabei auf der Erkenntnis, daß entgegen der üblichen Vorgehensweise der Fachwelt, bei der n- und p-leitendes Siliciumcarbid mit jeweils unterschiedlichem Material ohmsch kontaktiert wird, eine Kontaktierung von Siliciumcarbid beiden Leitungstyps dennoch mit einem einzigen Material möglich ist. Daraus ergeben sich wesentliche Vorteile bei der Herstellung, da die für ein davon verschiedenes Kontaktmaterial benötigten Prozeßschritte entfallen.

Für die Ausbildung eines guten ohmschen Kontakts ist es vorteilhaft, wenn das erste und zweite Halbleitergebiet jeweils eine ausreichend hohe Dotierstoffkonzentration zumindest an der Oberfläche des Halbleitergebietes aufweisen. Daher liegen die Dotierstoffkonzentrationen zwischen 10⁻¹⁷ cm⁻³ und 10²⁰ cm⁻³ . Ein besonders guter Kontakt ergibt sich, wenn die Dotierstoffkonzentration mindestens 10¹⁹ cm⁻³ beträgt. Diese Angaben gelten sowohl für den n- als auch den p-Lei tungstyp. Diese Dotierstoffkonzentrationen lassen sich beispielsweise mittels Ionenimplantation problemlos erzeugen.

Sie liegen insbesondere auch deutlich unter der im Stand der Technik genannten Dotierstoffkonzentration.

Entscheidend für die Ausbildung eines guten ohmschen Kontaktwiderstands sowohl auf dem n-leitenden als auch p-leitenden Siliciumcarbid ist hierbei, daß das Material nicht in Form eines Schichtaufbaus, sondern vielmehr mit praktisch homogener Materialzusammensetzung auf die jeweiligen Halbleitergebiete aufgebracht wird. Bei Zusammensetzung des Materials aus mehreren Materialkomponenten wird durch einen solchen homogenen Materialauftrag erreicht, daß an der Grenzfläche zu den beiden Halbleitergebieten jeweils alle Materialkomponenten unmittelbar vorhanden sind und mit dem Siliciumcarbid der beiden Halbleitergebiete in Wechselwirkung treten können. Demgegenüber ist bei einem Schichtaufbau zunächst eine Durchmischung der in Form von Einzelschichten mit einer Dicke in der Größenordnung einiger Nanometer aufgetragenen einzelnen Materialkomponenten erforderlich. Diese Durchmischung (= Homogenisierung) findet dabei insbesondere zu Beginn eines nach dem Materialauftrag durchgeführten Temperprozesses statt. Ein solcher Temperprozeß hat aber in erster Linie auch die Formierung der ohmschen Kontakte zum Ziel. Es ist nun von entscheidendem Vorteil, wenn bei diesem Temperprozeß alle relevanten Materialkomponenten des Materials für die beiden Kontaktgebiete unmittelbar an der Grenzfläche zu den Halbleitergebieten vorhanden sind. Dadurch wird die Formierung der ohmschen Kontakte wesentlich begünstigt.

Bei Aufbringen des gleichen Materials auf das erste und zweite Halbleitergebiet ist es gegebenenfalls je nach gewählter SiC-Dotierung und je nach für die beiden Kontaktgebiete verwendetem Material möglich, daß sich in einem ersten an das erste Halbleitergebiet angrenzenden Grenzbereich des ersten Kontaktgebiets und in einem zweiten an das zweite Halbleitergebiet angrenzenden Grenzbereich des zweiten Kontaktgebiets eine leicht voneinander abweichende Materialzusammensetzung einstellt. Diese geringfügige Abweichung rührt von unterschiedlichen Austauschvorgängen zwischen dem aufgebrachten Material und dem ersten oder dem zweiten Halbleitergebiet her.

Enthält das aufgebrachte Material beispielsweise eine Materialkomponente, die in Siliciumcarbid als Donator oder Akzeptor wirkt, so wird diese Materialkomponente in gewissem Umfang in das erste oder zweite Halbleitergebiet wandern, wo sie beispielsweise als Dotierstoff an den entsprechenden Gitterstellen eingebunden wird. Dieser Durchmischungsvorgang wird maßgeblich durch die ursprüngliche Dotierung des ersten oder zweiten Halbleitergebiets beeinflußt und verläuft somit im ersten und zweiten Grenzbereich unterschiedlich. Dadurch verändert sich der Anteil der betreffenden Materialkomponente zumindest im ersten und zweiten Grenzbereich in voneinander abweichendem, wenn auch sehr geringem Umfang.

Desgleichen ergibt sich eine Verschiebung der Materialzusammensetzung im Grenzbereich des ersten oder zweiten Kontaktgebiets, wenn das Material eine silicidbildende Materialkomponente enthält. In diesem Fall durchmischt sich Silicium, das aus dem ersten und zweiten Halbleitergebiet stammt, mit dem Material des ersten und zweiten Kontaktgebietes. Infolge bildet sich dann u.a. in den beiden Grenzbereichen ein Silicid auf Basis der Materialkomponente und des Siliciums. Auch bei diesem Prozeß sind Dotierungsgrad und Leitungstyp maßgebliche Einflußfaktoren, so daß dieser Effekt ebenfalls zu einer leicht voneinander abweichenden Materialzusammensetzung im ersten und zweiten Grenzbereich führen kann.

In den von den Grenzflächen entfernter lokalisierten Bereichen der beiden Kontaktgebiete wirken sich die beschriebenen Grenzflächeneffekte nicht aus, so daß das Material in seiner ursprünglich aufgebrachten Zusammensetzung erhalten bleibt und sich somit in diesen Bereichen des ersten und zweiten Kontaktgebiets gleicht.

Bei der erfingungsgemäßen Lehre werden alle geringfügigen Unterschiede in der Materialzusammensetzung des ersten und zweiten Kontaktgebiets wie die, die auf den beschriebenen oder ähnlichen Grenzflächeneffekten beruhen, nicht als maßgeblich betrachtet und unter den Begriffen "zumindest annähernd gleiche Materialzusammensetzung" und "praktisch homogen" subsumiert.

Außerdem werden Unterschiede in der Materialzusammensetzung, die auf übliche, gegebenenfalls unterschiedliche Verunreinigungen in Ausgangssubstanzen zurückzuführen sind, hier ebenfalls als nicht maßgeblich betrachtet.

Es ist darüber hinaus im Rahmen der erfindungsgemäßen Lehre möglich, auf das erste und zweite Halbleitergebiet leicht unterschiedliches Material aufzubringen. Solange die Materialzusammensetzungen jedoch um weniger als 10% voneinander abweichen, werden sie hier ebenfalls als "zumindest annähernd gleich" bezeichnet.

Besondere Ausgestaltungen und Weiterbildungen der Halbleiteranordnung und des Verfahrens nach der Erfindung ergeben sich aus den jeweils abhängigen Unteransprüchen.

Das aufgebrachte Material setzt sich aus einer ersten und zweiten Materialkomponente zusammen. Die erste Materialkomponente besteht aus aus einem Werkstoff, der einen ohmschen Kontakt auf n-leitendem Siliciumcarbid bildet mit einem Kontaktwiderstand ≤ 10⁻¹ Ωcm², vorzugsweise ≤ 10⁻³ Ωcm² Die zweite Materialkomponente enthält dagegen ein Element der dritten Hauptgruppe des Periodensystems. Durch die erste Materialkomponente wird ein stabiler ohmscher Kontakt auf demjenigen Halbleitergebiet, das n-leitend ist, erzeugt, durch die zweite Materialkomponente entsteht dagegen ein stabiler ohmscher Kontakt auf dem p-leitenden Halbleitergebiet.

Die zweite Materialkomponente liegt mit einem Volumen-Anteil von 0,1 bis 50% in dem Material vor. Bevorzugt ist dabei ein Anteil von 0,5 bis 20%.

Erfindungsgemäß ist Die erste Materialkomponente Nickel und die zweite Materialkomponente Aluminium, d.h. das Material besteht ausschließlich aus Nickel und Aluminium Es zeichnet sich aufgrund des Nickels durch einen guten ohmschen Kontakt auf dem n-leitenden Halbleitergebiet aus.

Die Beimengung von Aluminium zum Nickel in dem oben angegebenen Konzentrationsbereich beeinträchtigt den Kontaktwiderstand auf dem n-leitenden Halbleitergebiet nicht oder nur geringfügig. Außerdem verhindert der Nickel-Anteil im Material auch die Bildung von flüssigen Aluminium-Inseln und das resultierende unerwünschte Abdampfen von Aluminium bei dem Temperprozeß, der zur Formierung des ohmschen Kontakts vorteilhafterweise durchgeführt wird.

Vorteilhafte Ausführungsformen des Verfahrens, die sich aus den entsprechenden Unteransprüchen ergeben, weisen im wesentlichen die gleichen Vorteile auf wie die obengenannten jeweils korrespondierenden Weiterbildungen der Halbleiteranordnung selbst.

Andere Ausbildungen des Verfahrens beziehen sich auf das Aufbringen des Materials auf das erste und zweite Halbleitergebiet.

Besonders vorteilhaft ist eine Ausbildung, bei der das erste und zweite Kontaktgebiet gleichzeitig hergestellt werden. Dadurch reduziert sich die Anzahl der im Vergleich zu einem, sukzessiven Aufbringen benötigten Prozeßschritte erheblich. Somit können kürzere Fertigungszyklen erreicht werden.

In einer weiteren Ausbildung des Verfahrens wird das Material, das auf die beiden Halbleitergebiete aufgebracht wird, zwei getrennten Quellen entnommen. Die Quellen enthalten dabei jeweils eine Materialkomponente, d.h. die erste oder die zweite. Die Entnahme erfolgt durch gleichzeitiges Verdampfen oder Zerstäuben (Sputtern). Die beiden Kontaktgebiete werden anschließend durch Abscheiden der Materialkomponenten auf dem ersten und zweiten Halbleitergebiet gebildet. Das Material für die beiden Kontaktgebiete entsteht dabei entweder noch in der Gasphase aus den einzelnen Materialkomponenten, im Laufe des Abscheidevorgangs oder erst danach. Durch die Prozeßparameter kann gewährleistet werden, daß ein bestimmtes beabsichtigtes Mischungsverhältnis eingehalten wird.

Eine alternative Ausbildung sieht dagegen vor, daß aus der ersten und zweiten Materialkomponente zunächst ein Quellmaterial hergestellt wird, das dann in einem zweiten Verfahrensschritt zerstäubt wird. Die herausgelösten Partikel des Materials bilden wie in der vorher beschriebenen Ausbildung die beiden Kontaktgebiete auf dem n- und p-leitenden Siliciumcarbid.

Bei einer anderen Ausbildung des Verfahrens werden die erste und die zweite Materialkomponente abwechselnd in dünnen Schichten auf die beiden Halbleitergebiete aufgetragen. Dies kann durch Sputtern aus zwei getrennten Quellen erfolgen, so daß abwechselnd in kurzer zeitlicher Abfolge jeweils nur eine der beiden Materialkomponenten aus der zugehörigen Quelle zerstäubt und als dünne Schicht auf den beiden Halbleitergebieten abgeschieden wird. Die resultierenden dünnen Schichten haben insbesondere nur eine Dicke in der Größenordnung einiger Ängström. Im Extremfall kann eine solche dünne Schicht auch nur aus einer einzigen Atomschicht, einer sog. Monolage, bestehen. Aufgrund der geringen Schichtdicke und der kurzen zeitlichen Abfolge bei der Schichtabscheidung wird auch dieser Materialauftrag der beiden Materialkomponenten hier noch als gleichzeitig bezeichnet. Eine Durchmischung der Atome dieser Monolagen (Homogenisierung) findet dann abhängig von den Prozeßbedingungen zumindest teilweise bereits während des Auftragens selbst oder gleich zu Beginn des sich anschließenden Temperprozesses statt. Aufgrund der geringen Schichtdicken dauert dieser Durchmischungsvorgang nur sehr kurze Zeit.

In einer vorteilhaften Ausführungsvariante wird die Halbleiteranordnung, nachdem die beiden Kontaktgebiete aufgebracht worden sind, einem kurzzeitigen Temperprozeß unterzogen. Bevorzugt wird die Halbleiteranordnung dabei auf eine Maximaltemperatur von mindestens 500°C, insbesondere von etwa 1000°C, erhitzt und dann für bis zu 2 Stunden, insbesondere für 2 Minuten, auf etwa dieser Maximaltemperatur gehalten. Der Temperprozeß kann aber auch nur aus einer Aufheizphase und einer unmittelbar folgenden Abkühlphase bestehen, ohne daß dazwischen eine Verweildauer bei einer Maximaltemperatur vorgesehen wird. Dieser Prozeß dient der Formierung der beiden Kontaktgebiete. Es zeigt sich, daß nach diesem Temperprozeß sowohl auf dem ersten als auch auf dem zweiten Halbleitergebiet, also auf n- und p-leitendem SiC, temperaturstabile Kontakte mit guter ohmscher Charakteristik und niedrigem Kontaktwiderstand resultieren.

In weiteren Ausführungsformen der Halbleiteranordnung sind das erste und zweite Kontaktgebiet auf einer gemeinsamen Schichtoberfläche oder auf verschiedenen Schichtoberflächen angeordnet. Für beide Ausführungsformen gelten die oben beschriebenen Weiterbildungsmöglichkeiten und Vorteile der Kontaktierung von n- und p-leitendem SiC mit dem gleichen Material in analoger Weise.

Des weiteren sind Ausführungsvarianten möglich, in denen die beiden Kontaktgebiete zusammenhängend oder auch getrennt ausgebildet sind. Dabei kann die Trennung der beiden Kontaktgebiete sowohl bereits während des Aufbringens des Materials durch entsprechende Maskentechnik als auch danach durch Abtragen von zuviel aufgebrachtem Material erfolgen. Für letzteres kommen gängige Technologien wie z.B. das Ätzen in Frage.

Die zu kontaktierenden beiden Halbleitergebiete können aus SiC verschiedenen Polytyps bestehen. Es gibt Ausführungsformen, bei denen SiC in Form von 6H-, 4H-, 15R- oder 3C-SiC für die beiden Halbleitergebiete verwendet wird. Andere Polytypen sind jedoch ebenfalls möglich.

Außerhalb des ersten und zweiten Halbleitergebiets kann die Halbleiteranordnung auch aus einem anderen Material als SiC bestehen. Deshalb ist in einer Ausführungsform zumindest ein weiteres Halbleitergebiet, beispielsweise ein Substrat, aus einem von SiC verschiedenen Material, beispielsweise aus Silicium (Si), Galliumarsenid (GaAs) oder Galliumnitrid (GaN), vorgesehen. Dieses Substrat ist dann zumindest mit dem ersten und zweiten Halbleitergebiet aus SiC zu einer hybriden Halbleiteranordnung integriert.

In einer Ausführungsform der Halbleiteranordnung befindet sich das erste und zweite Kontaktgebiet jeweils an einer frei zugänglichen Oberfläche der Halbleiteranordnung. Dies ist jedoch nicht zwingend notwendig. In anderen Weiterbildungen können das erste und zweite Kontaktgebiet auch durch Schichten, die in der Kontaktierung folgenden Prozeßschritten aufgebracht werden, bedeckt sein.

Ausführungsbeispiele gemäß der Erfindung werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen:
- Figur 1: eine Halbleiteranordnung mit zwei zusammenhängenden Kontaktgebieten,
- Figur 2: eine Halbleiteranordnung mit zwei getrennten Kon- taktgebieten,
- Figur 3: eine nicht -erfindungsgemäße Halbleiteranordnung mit zwei getrennten Kontaktgebieten und
- Figur 4: eine Halbleiteranordnung in Form eines vertikalen MOSFET's unter Verwendung der Halbleiteranordnungen von Figur 1 und 2.

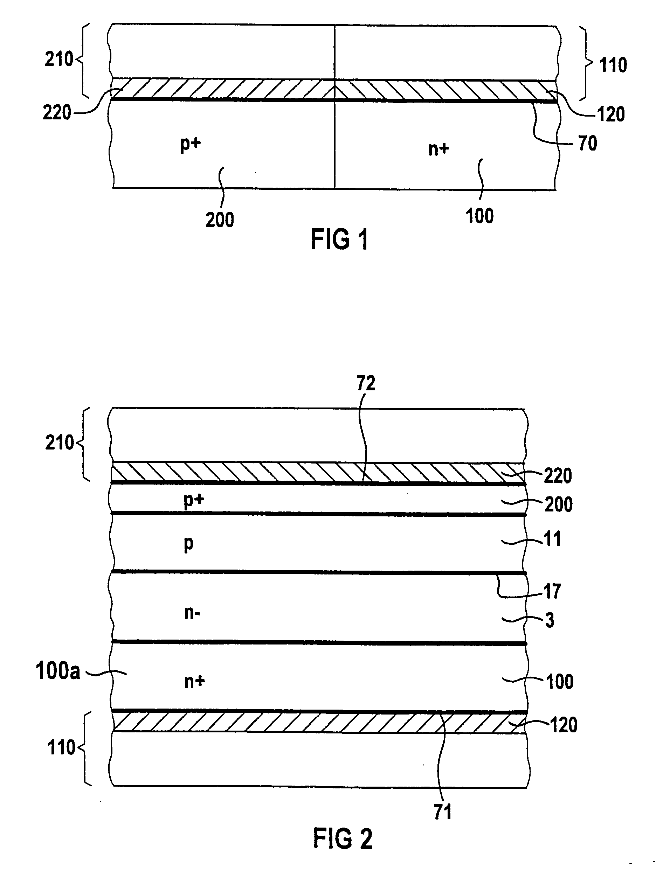

Einander entsprechende Teile sind in den Figuren 1 bis 4 mit denselben Bezugszeichen versehen.

In Figur 1 ist eine Halbleiteranordnung dargestellt, bei der sich ein erstes Kontaktgebiet 110 und ein zweites Kontaktgebiet 210 als zusammenhängende Schicht über ein erstes Halbleitergebiet 100 und ein diesem benachbartes zweites Halbleitergebiet 200 erstrecken. Das erste und zweite Halbleitergebiet 100 und 200 bestehen jeweils aus 6H-Siliciumcarbid. Sie besitzen eine gemeinsame Schichtoberfläche 70, auf der das erste und zweite Kontaktgebiet 110 und 210 angeordnet sind.

Das erste Halbleitergebiet 100 ist mit einem hohen Anteil an Donatoren, im vorliegenden Fall mit Stickstoff, dotiert und somit n-leitend. Das zweite Halbleitergebiet 200 weist dagegen eine hohe Dotierstoffkonzentration an Aluminium auf. Aluminium stellt in Siliciumcarbid einen Akzeptor dar, so daß das zweite Halbleitergebiet folglich p-leitend ist. Die Donatoren und Akzeptoren werden mittels Ionenimplantation in das erste bzw. zweite Halbleitergebiet 100 bzw. 200 eingebracht. Die Dotierstoffkonzentrationen im ersten und zweiten Halbleitergebiet 100 und 200 liegen bei jeweils 10¹³ cm⁻³. Diese hohen Dotierstoffkonzentrationen werden in der Figur 1 durch die Symbole n⁺ und p⁻ angezeigt.

Zur temperaturstabilen ohmschen Kontaktierung befinden sich auf dem ersten und zweiten Halbleitergebiet 100 und 200 das erste und zweite Kontaktgebiet 110 und 210. Die beiden Kontaktgebiete 110 und 210 bestehen aus dem gleichen Material, das sich aus einer ersten und einer zweiten Materialkomponente zusammensetzt. Die erste Materialkomponente ist Nickel, die zweite Aluminium. Für Aluminium liegt der Volumen-Anteil bei etwa 10%.

Das Material für das erste und das zweite Kontaktgebiet 110 und 210 wird durch Verdampfen aus nicht dargestellten, getrennten Nickel- bzw. Aluminium-Quellen erzeugt. Anschließend erfolgt die Bildung des ersten und zweiten Kontaktgebiets 110 und 210 durch Abscheiden des gasförmigen Materials auf dem ersten und zweiten Halbleitergebiet 100 und 200. Zur Formierung und zur Bildung ohmscher, temperaturstabiler Kontakte wird die Halbleiteranordnung von Figur 1 anschlieβend einem ca. zweiminütigem Temperprozeß bei etwa 1000°C unterzogen. Danach ergibt sich zwischen dem ersten Halbleitergebiet 100 (n-leitend) und dem ersten Kontaktgebiet 110 ein Kontaktwiderstand von unter 10⁻⁴ Ωcm² und zwischen dem zweiten Halbleitergebiet 200 (p-leitend) und dem zweiten Kontaktgebiet 210 ein Kontaktwiderstand von unter 10⁻³ Ωcm².

In Figur 1 sind Grenzbereiche des ersten und zweiten Kontaktgebiets 110 und 210 mit den Bezugszeichen 120 bzw. 220 gekennzeichnet. Innerhalb dieser Grenzbereiche 120 und 220 ergeben sich aufgrund von Austauschvorgängen zwischen dem ersten Halbleitergebiet 100 und dem ersten Kontaktgebiet 110 sowie dem zweiten Halbleitergebiet 200 und dem zweiten Kontaktgebiet 210 geringfügige Veränderungen in der Zusammensetzung des ursprünglich im ersten und zweiten Kontaktgebiet 110 und 210 aufgebrachten Materials. Abgesehen von den resultierenden geringfügigen Unterschieden in der Materialzusammensetzung des ersten und des zweiten Grenzbereichs 120 und 220 weisen das erste und das zweite Kontaktgebiet 110 und 210 die gleiche Materialzusammensetzung auf. Es ist ebenfalls möglich, daß sich die Grenzbereiche 120 und 220, in denen die genannten Austauschvorgänge stattfinden, auch bis in die Halbleitergebiete 100 bzw. 200 erstrecken. In Figur 1 ist dieser Fall allerdings nicht dargestellt.

Figur 2 zeigt eine Halbleiteranordnung in einer Schichtfolge mit dem ersten Kontaktgebiet 110 als unterster Schicht, dem zweiten Kontaktgebiet 210 als oberster Schicht sowie mehreren dazwischenliegenden SiC-Schichten. Das erste und zweite Kontaktgebiet 110 und 210 weisen wiederum den an die jeweilige benachbarte SiC-Schicht angrenzenden ersten bzw. zweiten Grenzbereich 120 und 220 auf. Der Teilstapel aus den SiC-Schichten setzt sich in aufsteigender Reihenfolge aus dem ersten Halbleitergebiet 100, einer n⁻-SiC-Schicht 3, einer p-SiC-Schicht 11 sowie dem zweiten Halbleitergebiet 200 zusammen. Das erste Kontaktgebiet 110 ist dabei auf einer ersten Schichtoberflächen 71 des ersten Halbleitergebiets 100, die zugleich auch eine untere Hauptoberfläche des Teilstapels aus den SiC-Schichten bildet, angeordnet. Das zweite Kontaktgebiet 210 ist auf einer zweiten Schichtoberflächen 72 des zweiten Halbleitergebiets 200, die zugleich eine obere Hauptoberfläche des Teilstapels aus den SiC-Schichten bildet, angeordnet.

Das erste Halbleitergebiet 100, das im Ausführungsbeispiel von Figur 2 auch ein SiC-Substrat 100a darstellen kann, besitzt wieder eine hohe n-Leitfähigkeit, das zweite Halbleitergebiet 200 dagegen eine hohe p-Leitfähigkeit. Die im ersten und zweiten Halbleitergebiet 100 und 200 sowie im ersten und zweiten Kontaktgebiet 110 und 210 vorgesehenen Materialien und Dotierstoffe entsprechen denen des Ausführungsbeispiels von Figur 1. Diese Analogie gilt auch für das Verfahren zum Aufbringen des ersten und zweiten Kontaktgebiets 110 und 210.

Die Halbleiteranordnung von Figur 2 besitzt zwischen der n⁻-SiC-Schicht 3 und der p-Schicht 11 einen pn-Übergang 17, der die Funktion dieser Halbleiteranordnung wesentlich bestimmt. Ein derartiger pn-Übergang 17 kann sowohl Bestandteil einer größeren Schaltungsanordnung sein, als auch ein eigenes Bauelement in Form einer pn-Diode darstellen. In beiden Fällen ist eine ohmsche Kontaktierung von Halbleitergebieten unterschiedlichen Leitungstyps über die Kontaktgebiete 110 und 210 notwendig.

Die in Figur 2 gezeigte Ausführungsform ist ein Beispiel für eine Halbleiteranordnung mit erstem und zweiten Kontaktgebiet 110 und 210 auf verschiedenen Schichtoberflächen 71 und 72 der Halbleiteranordnung.

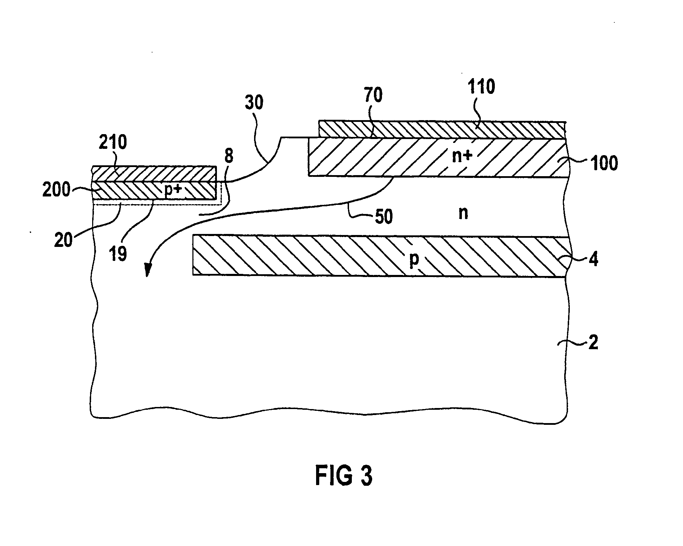

In Figur 3 ist eine Halbleiteranordnung dargestellt, bei der das erste und das zweite Kontaktgebiet 110 und 210 auf der gemeinsamen Schichtoberfläche 70 der Halbleiteranordnung angeordnet sind, jedoch im Unterschied zu dem Ausführungsbeispiel von Figur 1 räumlich getrennt voneinander sind.

Die Funktion der Halbleiteranordnung von Figur 3 besteht darin, einen Stromfluß 50, der vom ersten Halbleitergebiet 100 bzw. vom ersten Kontaktgebiet 110 ausgeht und der durch eine n-SiC-Schicht 2 verläuft, innerhalb eines Kanalbereichs 8 dieser n-SiC-Schicht 2 zu steuern. Dazu kann der Kanalbereich 8 durch das zweite Halbleitergebiet 200 und eine in der n-SiC-Schicht 2 vergrabene p-Insel 4 in seinen Dimensionen und damit seinem Widerstand verändert werden. Dies geschieht über das Anlegen einer Spannung an das zweite Kontaktgebiet 210, wodurch sich eine Verarmungszone 20 an einem pn-Übergang 19 zwischen der n-SiC-Schicht 2 und dem p-leitenden zweiten Halbleitergebiet 200 u.a. in den Kanalbereich 8 hinein ausbreitet. Die Dimension des Kanalbereichs 8 wird zusätzlich voreingestellt, indem eine Vertiefung 30 vorgesehen ist, in der sich das zweite Halbleitergebiet 200 befindet.

Sowohl das n-leitende erste Halbleitergebiet 100 als auch das p-leitende zweite Halbleitergebiet 200 benötigen für die beschriebene Funktionsweise eine ohmsche Kontaktierung in Form des ersten und zweiten Kontaktgebiets 110 und 210.

Das erste Halbleitergebiet 100 weist eine n-Dotierung mit dem Donator Phosphor auf, das zweite Halbleitergebiet 200 eine p-Dotierung mit dem Akzeptor Bor. Die Dotierstoffkonzentration beträgt jeweils 10¹⁹ cm⁻³. Als Material für das erste und das zweite Kontaktgebiet 110 und 210 dient im Beispiel von Figur 3, das nicht unter die Erfindung fällt, ein Materialgemisch, das sich aus der ersten Materialkomponente Wolfram und der zweiten Materialkomponente Gallium zusammensetzt. Der Volumen-Anteil von Gallium beträgt hierbei etwa 5%. Das Aufbringen des Materialgemischs sowie der anschließende Temperprozeß erfolgen wie im Zusammenhang mit Figur 1 und 2 bereits beschrieben.

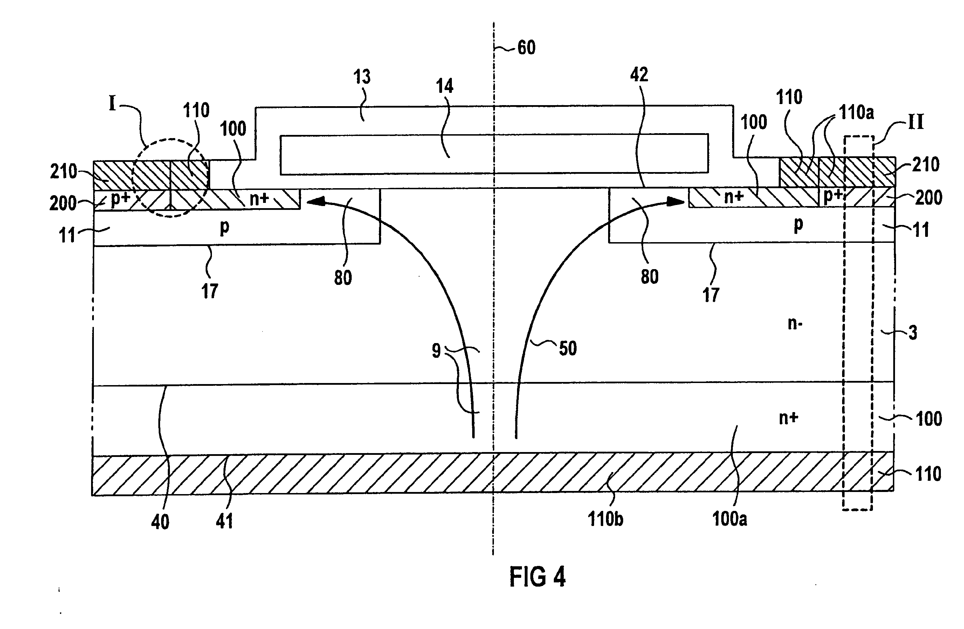

Die Figur 4 zeigt eine Halbleiteranordnung in Form eines vertikalen MOSFET's auf Basis von Siliciumcarbid. Der MOSFET beinhaltet dabei mehrere erste und zweite Halbleitergebiete 100 und 200. Die in den Figuren 1 und 2 gezeigten Halbleiteranordnungen finden sich in dem MOSFET von Figur 4 als Teilstrukturen wieder. Sie sind durch einen gestrichelten Kreis bzw. ein gestricheltes Rechteck kenntlich gemacht.

Der vertikale MOSFET von Figur 4 ist spiegelsymmetrisch bezüglich einer Symmetrieebene 60. Analog zu Figur 2 wird das in der dargestellten Schichtfolge zuunterst liegende erste Halbleitergebiet 100 auch im Zusammenhang mit Figur 4 als Substrat 100a bezeichnet. Auf dessen einer senkrecht zur Symmetrieebene 60 gerichteten Oberfläche 40 ist die n⁻-SiC-Schicht 3 angeordnet. Innerhalb dieser n⁻-SiC-Schicht 3 befinden sich an einer vom SiC-Substrat 100a abgewandten Oberfläche 42 zwei separate, bezüglich der Symmetrieebene 60 spiegelsymmetrisch angeordnete p-Schichten 11. Diese beinhalten ihrerseits jeweils ein erstes und zweites Halbleitergebiet 100 und 200, die aneinandergrenzen. Das erste und zweite Halbleitergebiet 100 und 200 sind durch die hier zusammenhängenden ersten und zweiten Kontaktgebiete 110 und 210 elektrisch kontaktiert. Die zusammenhängenden ersten und zweiten Kontaktgebiete 110 und 210 können in dem in Figur 4 dargestellten Ausführungsbeispiel auch als eine Source-Elektrode 110a angesehen werden. Auf einer von der n⁻-SiC-Schicht 3 abgewandten Oberfläche 41 des SiC-Substrats 100a befindet sich ein weiteres erstes Kontaktgebiet 110, das hier auch als eine Drain-Elektrode 110b angesehen werden kann.

Ähnlich dem in Figur 3 beschriebenen Ausführungsbeispiel besteht die Funktionsweise des vertikalen MOSFET's von Figur 4 darin, den Stromfluß 50 zwischen der Drain-Elektrode 110b und der Source-Elektrode 110a zu steuern. Der Stromfluß 50 durchläuft dabei einen vertikalen Driftbereich 9 im SiC-Substrat 100a und in der n⁻-SiC-Schicht 3 sowie einen lateralen Kanalbereich 80 in der p-Schicht 11. Der Widerstand des Kanalbereichs 80 kann über eine Gate-Elektrode 14 eingestellt werden, wobei eine elektrisch isolierende Oxidschicht 13 die Gate-Elektrode 14 vom Kanalbereich 80 in der p-Schicht 11 trennt.

Wie das Ausführungsbeispiel des MOSFET's demonstriert, wird gerade auch in komplexeren Halbleiteranordnungen häufig eine elektrische Kontaktierung von ersten und zweiten Halbleitergebieten 100 und 200 mit verschiedenem Leitungstyp benötigt. Die Kontaktierung erfolgt dabei wie in den Beispielen der Figuren 1 bis 3 bereits beschrieben. In einer nicht dargestellten Ausführungsform sind mehrere der in den Figuren 1 bis 4 gezeigten Halbleiteranordnungen Bestandteil einer komplexen Halbleiteranordnung, die folglich eine Vielzahl von ersten und zweiten Halbleitergebieten 100 und 200 nebst der Kontaktierung über die zugehörigen ersten und zweiten Kontaktgebiete 110 und 210 beinhaltet.

## Patentansprüche

1. Halbleiteranordnung mit ohmscher Kontaktierung, wobei die Halbleiteranordnung aufweist:
a) mindestens ein aus n-leitendem Siliciumcarbid bestehendes erstes Halbleitergebiet (100),
b) mindestens ein aus p-leitendem Siliciumcarbid bestehendes zweites Halbleitergebiet (200), wobei die Dotierstoffkonzentrationen des n-leitenden Siliciumcarbids und des p-leitenden Siliciumcarbids jeweils im Bereich zwischen 10¹⁷ cm⁻³ und 10²⁰ cm⁻³ liegen,
c) mindestens ein an das erste Halbleitergebiet (100) anangrenzendes erstes Kontaktgebiet (110) und
d) mindestens ein an das zweite Halbleitergebiet (200) angrenzendes zweites Kontaktgebiet (210),
e) wobei das erste und das zweite Kontaktgebiet (110, 210) das erste und das zweite Halbleitergebiet jeweils ohmsch kontaktieren und aus dem gleichen, praktisch homogenen und ausschließlich Nickel und Aluminium enthaltenden Material bestehen, wobei der Volumenanteil des Aluminiums im Bereich zwischen 0,1% und 50% liegt.

2. Halbleiteranordnung nach Anspruch 1, **dadurch**
**gekennzeichnet, daß** das erste und das zweite Kontaktgebiet (110, 210) auf einer gemeinsamen Schichtoberfläche (70) angeordnet sind.

3. Halbleiteranordnung nach Anspruch 1, **dadurch gekennzeichnet, daß** das erste und das zweite Kontaktgebiet (110, 210) auf verschiedenen Schichtoberflächen (71, 72) angeordnet sind.

4. Halbleiteranordnung nach Anspruch 1 oder 2, **dadurch gekennzeichnet, daß** das erste und das zweite Kontaktgebiet (110, 210) zusammenhängend ausgebildet sind.

5. Halbleiteranordnung nach einem der Ansprüche 1 bis 3,
**dadurch gekennzeichnet, daß** das erste und das zweite Kontaktgebiet (110, 210) getrennt ausgebildet sind.

6. Halbleiteranordnung nach einem der Ansprüche 1 bis 5,
**dadurch gekennzeichnet, daß** der Volumenanteil des Aluminiums im Bereich zwischen 0,5% und 20% liegt.

7. Verfahren zur ohmschen Kontaktierung einer Halbleiteranordnung, bei dem
ein erstes Kontaktgebiet (110) auf einem aus n-leitendem Siliciumcarbid bestehenden, eine im Bereich zwischen 10¹⁷ cm⁻³ und 10²⁰ cm⁻³ liegende Dotierstoffkonzentration aufweisenden ersten Halbleitergebiet (100) und ein zweites Kontaktgebiet (210) auf einem aus p-leitendem, Siliciumcarbid bestehenden, eine im Bereich zwischen 10¹⁷ cm⁻³ und 10²⁰ cm⁻³ liegende Dotierstoffkonzentration aufweisenden zweiten Halbleitergebiet (200) durch Aufbringen des gleichen, praktisch homogenen und ausschließlich Nickel und Aluminium enthaltenden Materials derart erzeugt werden, dass der Volumenanteil des Aluminiums in dem Material zwischen 0,1% und 50% liegt.

8. Verfahren nach Anspruch 7, **dadurch gekennzeichnet, daß** das erste und das zweite Kontaktgebiet (110, 210) gleichzeitig auf das erste und zweite Halbleitergebiet (100, 200) aufgebracht werden.

9. Verfahren nach Anspruch 7 oder 8, **dadurch gekennzeichnet, dass** der Volumenanteil des Aluminiums in dem aufgebrachten Material im Bereich zwischen 0,5% und 20% liegt.

10. Verfahren nach einem der Ansprüche 7 bis 9, **dadurch gekennzeichnet, daß** das Material durch gleichzeitiges Verdampfen oder Zerstäuben aus einer Nickelquelle und einer Aluminiumquelle aufgebracht wird.

11. Verfahren nach einem der Ansprüche 7 bis 9, **dadurch gekennzeichnet, daß** eine Nickel und Aluminium enthaltende Quelle vorab hergestellt wird und das Material dann durch Zerstäuben des Quellenmaterials aufgebracht wird.

12. Verfahren nach einem oder Ansprüche 7 bis 11, **dadurch gekennzeichnet, daß** die das erste und zweite Halbleitergebiet (100, 200) sowie das aufgebrachte erste und zweite Kontaktgebiet (110, 210) umfassende Halbleiteranordnung einem Temperprozeß mit einer Erhitzung auf eine Maximaltemperatur von mindestens 500°C, vorzugsweise von etwa 1000°C, unterzogen wird.

13. Verfahren nach Anspruch 12, **dadurch gekennzeichnet, daß** die Maximaltemperatur für eine Dauer von höchstens 2 Minuten bis höchstens 2 Stunden konstant gehalten wird.

## Claims

1. Semiconductor arrangement with ohmic contact-connection, the semiconductor arrangement having:
a) at least one first semiconductor region (100) made of n-conducting silicon carbide,
b) at least one second semiconductor region (200) made of p-conducting silicon carbide, the dopant concentration of the n-conducting silicon carbide and the p-conducting silicon carbide in each case being in the range of between 10¹⁷ cm⁻³ and 10²⁰ cm⁻³,
c) at least one first contact region (110) adjoining the first semiconductor region (100), and
d) at least one second contact region (210) adjoining the second semiconductor region (200),
e) the first and second contact regions (110, 210) respectively making ohmic contact with the first and second semiconductor regions and being made of the same, practically homogeneous material containing exclusively nickel and aluminium, the proportion by volume of aluminium being in the range of between 0.1% and 50%.

2. Semiconductor arrangement according to Claim 1, **characterized in that** the first and second contact regions (110, 210) are arranged on a common layer surface (70).

3. Semiconductor arrangement according to Claim 1, **characterized in that** the first and second contact regions (110, 210) are arranged on different layer surfaces (71, 72).

4. Semiconductor arrangement according to Claim 1 or 2, **characterized in that** the first and second contact regions (110, 210) are formed such that they are contiguous.

5. Semiconductor arrangement according to one of Claims 1 to 3, **characterized in that** the first and second contact regions (110, 210) are formed such that they are separate.

6. Semiconductor arrangement according to one of Claims 1 to 5, **characterized in that** the proportion by volume of aluminium is in the range of between 0.5% and 20%.

7. Method for making ohmic contact with a semiconductor arrangement in which a first contact region (110) is produced on a first semiconductor region (100), which is made of n-conducting silicon carbide and has a dopant concentration in the range of between 10¹⁷cm⁻³ and 10²⁰cm⁻³, and a second contact region (210) is produced on a second semiconductor region (200), which is made of p-conducting silicon carbide and has a dopant concentration in the range of between 10¹⁷cm⁻³ and 10²⁰cm⁻³, by applying the same, practically homogeneous material containing exclusively nickel and aluminium in such a way that the proportion by volume of aluminium in the material is between 0.1% and 50%.

8. Method according to Claim 7 **characterized in that** the first and second contact regions (110, 210) are applied simultaneously to the first and second semiconductor regions (100, 200).

9. Method according to Claim 7 or 8, **characterized in that** the proportion by volume of aluminium in the applied material is in the range of between 0.5% and 20%.

10. Method according to one of Claims 7 to 9, **characterized in that** the material is applied by simultaneous vaporization or sputtering from a nickel source and an aluminium source.

11. Method according to one of Claims 7 to 9, **characterized in that** a source containing nickel and aluminium is prepared in advance and the material is then applied by sputtering the source material.

12. Method according to one of Claims 7 to 11 **characterized in that** the semiconductor arrangement comprising and first and second semiconductor regions (100, 200) and the applied first and second contact regions (110, 210) is subjected to a heat-treatement process with heating to a maximum temperature of at least 500°C, preferably of about 1000°C.

13. Method according to Claim 12, **characterized in that** the maximum temperature is kept constant for a duration of at most 2 minutes to at most 2 hours.

## Revendications

1. Dispositif à semi-conducteur avec contact ohmique, ledit dispositif à semi-conducteur comprenant :
a) au moins une première région semi-conductrice (100), constituée de carbure de silicium de type n,
b) au moins une seconde région semi-conductrice (200), constituée de carbure de silicium de type p, les concentrations de dopant du carbure de silicium de type n et du carbure de silicium de type p étant chacune comprises entre 10¹⁷cm⁻³ et 10²⁰ cm⁻³,
c) au moins une première région de contact (110), adjacente à la première région semi-conductrice (100), et
d) au moins une seconde région de contact (210), adjacente à la seconde région semi-conductrice (200),
e) la première et la seconde région de contact (110, 210) réalisant chacune un contact ohmique et étant constituées du même matériau pratiquement homogène et contenant exclusivement du nickel et de l'aluminium, la fraction volumique de l'aluminium étant comprise entre 0,1 % et 50 %.

2. Dispositif à semi-conducteur selon la revendication 1, **caractérisé en ce que** la première et la seconde région de contact (110, 210) sont disposées sur une surface de couche commune (70).

3. Dispositif à semi-conducteur selon la revendication 1, **caractérisé en ce que** la première et la seconde région de contact (110, 210) sont disposées sur des surfaces de couches différentes (71, 72).

4. Dispositif à semi-conducteur selon la revendication 1 ou 2, **caractérisé en ce que** la première et la seconde région de contact (110, 210) sont conçues de manière contigüe.

5. Dispositif à semi-conducteur selon l'une des revendications 1 à 3, **caractérisé en ce que** la première et la seconde région de contact (110, 210) sont conçues de manière séparée.

6. Dispositif à semi-conducteur selon l'une des revendications 1 à 5, **caractérisé en ce que** la fraction volumique de l'aluminium est comprise entre 0,5 % et 20 %.

7. Procédé de réalisation d'un contact ohmique sur un dispositif à semi-conducteur, dans lequel
il est créé une première région de contact (110) sur une première région semi-conductrice (100) constituée de carbure de silicium de type n et ayant une concentration de dopant comprise entre 10¹⁷ cm⁻³ et 10²⁰ cm⁻³, et une seconde région de contact (210) sur une seconde région semi-conductrice (200) constituée de carbure de silicium de type p et ayant une concentration de dopant comprise entre 10¹⁷ cm⁻³ et 10²⁰ cm⁻³, en déposant le même matériau pratiquement homogène et contenant exclusivement du nickel et de l'aluminium, de telle manière que la fraction volumique de l'aluminium soit comprise entre 0,1 % et 50 %.

8. Procédé selon la revendication 7, **caractérisé en ce que** la première et la seconde région de contact (110, 210) sont déposées simultanément sur la première et la seconde région semi-conductrice (100, 200).

9. Procédé selon la revendication 7 ou 8, **caractérisé en ce que** la fraction volumique de l'aluminium dans le matériau déposé est comprise entre 0,5 % et 20 %.

10. Procédé selon l'une des revendications 7 à 9, **caractérisé en ce que** le matériau est déposé par vaporisation ou pulvérisation simultanée à partir d'une source de nickel et une source d'aluminium.

11. Procédé selon l'une des revendications 7 à 9, **caractérisé en ce qu'**une source contenant du nickel et de l'aluminium est d'abord fabriquée, puis le matériau est déposé par pulvérisation du matériau source.

12. Procédé selon l'une des revendications 7 à 11, **caractérisé en ce que** le dispositif à semi-conducteur, comprenant la première et la seconde région semi-conductrices (100, 200) ainsi que la première et la seconde région de contact déposées (110, 210), est soumis à un processus de recuit avec un chauffage jusqu'à une température maximale au moins égale à 500°C, de préférence de l'ordre de 1000°C.

13. Procédé selon la revendication 12, **caractérisé en ce que** la température maximale est maintenue constante pendant une durée comprise entre 2 minutes tout au plus et 2 heures tout au plus.
